# EUROPEAN PATENT SPECIFICATION

(11) **EP 0 713 143 B1**
(45) Date of publication and mention of the grant of the patent: **26.04.2000**
(21) Application number: 95117807.8
(22) Date of filing: 10.11.1995
(51) Int. Cl.: G03F 7/105, G03F 7/022

(54) **Photosensitive planographic printing plate**
Lichtempfindliche Flachdruckplatte
Plaque photosensible pour l'impression planographique

(30) Priority: 18.11.1994 JP 28544794
(43) Date of publication of application: 22.05.1996
(73) Proprietor: FUJI PHOTO FILM CO., LTD., Kanagawa-ken (JP)
(72) Inventor: Nagashima, Akira, c/o Fuji Photo Film Co., Ltd., Haibara-gun, Shizuoka (JP); Kawamura, Koichi, c/o Fuji Photo Film Co., Ltd., Haibara-gun, Shizuoka (JP)
(74) Representative: Grünecker, Kinkeldey, Stockmair & Schwanhäusser Anwaltssozietät

(56) References cited:
- EP-A- 0 566 353
- EP-A- 0 684 521
- US-A- 4 160 671
- US-A- 4 457 025
- US-A- 4 544 627
- PATENT ABSTRACTS OF JAPAN vol. 16, no. 46 (P-1307), 5 February 1992 & JP 03 249651 A (KONICA CORP. ET AL.), 7 November 1991,

## Description

### FIELD OF THE INVENTION

The present invention relates to a photosensitive planographic printing plate, and particularly to one which has high sensitivity, improved suitability for plate inspection to a developed printing plate, greater ease with which register marks can be visually observed, and in addition, improved safety against a white lamp.

### BACKGROUND OF THE INVENTION

In some cases, photosensitive planographic printing plates are inevitably exposed to a white lamp or a fluorescent lamp comprising white light and yellow light before development in a process of platemaking. When o-naphthoquinonediazide absorbing in the 400-450 nm region is used as a photosensitive material, the compound absorbs at 436 nm in the bright line spectrum of the white lamp, which causes fogging (lack of halftone dots and change in tone). Although addition of a yellow compound absorbing at 436 nm would be expected to inhibit the fogging, this wavelength exists in the vicinity of the center of the wave range of light absorbed by o-naphthoquinonediazide. Hence, compounds which can inhibit the fogging caused by the white lamp absorb at the wavelength at which o-naphthoquinonediazide also absorbs, often resulting in lowering the sensitivity of the photosensitive planographic printing plates.

Further, the photosensitive planographic printing plates are plate-inspected after development to confirm the presence of unnecessary images and dust thereon. Then, the developed printing plate which exhibits a good contrast (ΔD) between image and non-image areas can be easily plate-inspected. Hence, a blue-colorant is generally used to obtain a sharp contrast between the image and non-image areas.

Although increase in blue density would be expected to fully improve the suitability for plate inspection to the developed printing plates, a sufficient contrast results in lowering a yellowish tone owing to an o-naphthoquinonediazide as a whole, and in the image areas, a bluish tone increases and a greenish tone decreases.

On the other hand, in order to register a film with the photosensitive planographic printing plate, a register mark is put on the printing plate with a blue ball point pen. However, as the register is conducted under a yellow lamp, a shift of the image areas from a green tint to a blue tint makes it very difficult to visually observe the register mark.

Further, although the plate-inspection of the developed printing plate is often carried out under the white lamp, the shift of the image areas to the blue tint were found to make it difficult to visually inspect, as compared with image areas of an original green tint.

To solve these problems, it is effective to shift the image areas from a blue tint to a green tint by adding a yellow-orange colorant absorbing in the 400-500 nm region. However, although the green tint of the image areas makes register marks easier to visually observe and improves the suitability for plate inspection to the developed printing plates, wavelengths of light absorbed by the yellow-orange colorant overlap with wavelengths of light absorbed by the above-mentioned o-naphthoquinonediazide to cause decrease in the sensitivity of the photosensitive planographic printing plates.

It has been a difficult problem to obtain the photosensitive planographic printing plate having great safety against the white lamp without any decrease in sensitivity, because the wavelengths of light absorbed by o-naphthoquinonediazide being the photosensitive material overlap with one in the bright line spectrum of the white lamp.

Similarly, the shift of the image areas from a blue tint to a green tint has also faced a problem difficult to solve, because the wavelengths of light absorbed by the yellow-orange colorant overlap with ones of light absorbed by o-naphthoquinonediazide.

### SUMMARY OF THE INVENTION

An object of the present invention is to provide photosensitive planographic printing plates which have improved safety against a white lamp, improved suitability for plate inspection to developed printing plates, and further greater ease with which register marks can be visually observed without any decrease in sensitivity.

The object of the present invention has been achieved by the following items (1) to (3):
(1) A photosensitive planographic printing plate comprising a support having thereon a photosensitive composition on a support, wherein the photosensitive composition comprises a) an o-naphthoquinonediazide compound; b) an aqueous alkali-soluble, water-insoluble polymer; c) a blue-colorant; and d) a colorant of which the proportion of absorbance at wavelengths of 436 nm, 417 nm and 500 nm is 100 : 65 or less : 40 or less.
   Particularly preferably, the above components a), b), c) and d) are used in an amount of 10 to 80 % by weight, 20 to 80 % by weight, 0.2 to 5 % by weight and 0.05 to 3 % by weight, respectively.
(2) The photosensitive planographic printing plate as described in the above item (1), wherein the colorant of item d) is a compound represented by formula [I]: 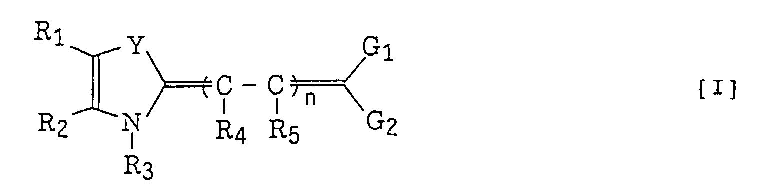 wherein R₁ and R₂, each represents an alkyl group having 1 to 10 carbon atoms which may be substituted or an aryl group having 1 to 10 carbon atoms which may be substituted; R₃ represents an alkyl group having 1 to 10 carbon atoms; R₄ and R₅, each represents a hydrogen atom or an alkyl group having 1 to 10 carbon atoms which may be substituted; G₁ and G₂, each represents an alkoxycarbonyl group, an aryloxycarbonyl group, an acyl group, an arylcarbonyl group, an alkylthio group, an arylthio group, an alkylsulfonyl group, an arylsulfonyl group, or a fluoroalkylsulfonyl group; Y represents a divalent atom or an atomic group selected from the group consisting of O, S, -NR-, Se, -C(CH₃)₂-, and -CH=CH-, wherein R has the same meaning as R₃ ; and n represents 0 or 1; R₁ and R₂ may combine to form a ring; and G₁ and G₂ may combine to form a ring.
(3) The photosensitive planographic printing plate as described in the above item (1), wherein the colorant of item d) is a compound represented by formula [II]: 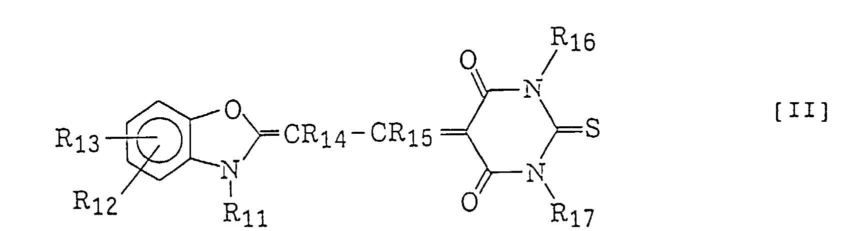 wherein R₁₁, R₁₂, R₁₃, R₁₄, R₁₅, R₁₆, and R₁₇, each represents a hydrogen atom, a halogen atom, an alkyl group, a substituted alkyl group, an aryl group, a substituted aryl group, an allyl group or a substituted allyl group; and R₁₂ and R₁₃ may combine to form a ring together with the respective carbon atoms to which R₁₂ and R₁₃ link.

Particularly preferably, R₁₁ represents an alkyl group which may contain a substituent group (for example, alkoxyl, aryloxy, carboxyl, hydroxysulfonyl, halogen, among these, the carboxyl group is preferred.); R₁₂ and R₁₃, each preferably represents a hydrogen atom, a halogen atom, an aryl group which may be substituted, or an alkyl group which may be substituted and, further, R₁₂ and R₁₃ may combine to form a ring; R₁₄ and R₁₅, each preferably represents a hydrogen atom, a halogen atom, or an alkyl group which may be substituted; and R₁₆ and R₁₇, each preferably represents an alkyl group which may contain a substituent group (for example, alkoxyl, aryloxy, carboxyl, hydroxy-sulfonyl, halogen, among these, the carboxyl group is preferred.) or an aryl group.

### DETAILED DESCRIPTION OF THE INVENTION

According to the above-mentioned items, the present invention can provide the photosensitive planographic printing plates which have good safety against the white lamp, good suitability for plate inspection to the developed printing plates, and greater ease with which the register marks can be visually observed, maintaining their high sensitivity.

In the present invention, in view of absorption spectrum of colorants, use of only yellow-orange colorants having specific absorption wavelengths and absorption distribution does not inhibit absorption of light by o-naphthoquinonediazide, efficiently absorbs at 436 nm in the bright line specrum of the white lamp which causes the fogging, and adds a yellowish tone to the blue tint of the image areas, which makes the register marks easier to visually observe and, in addition, improves the suitability for plate inspection to the developed printing plates.

That is, in order to obtain high sensitivity and to add the yellowish tone to the blue tint of the image areas, preferred yellow-orange colorants used in the present invention are those (i.e., dyes) which have absorption peaks in the vicinity of the center of the 400-500 nm region and exhibit weak absorption in the first half of this region.

This is explained in more detail below.

The wavelengths of light emitted by a lamp mounted in an exposure machine used for the photosensitive planographic printing plates of the present invention are 405 nm, 417 nm and 436 nm. Hence, preferred yellow colorants are those which absorb at 417 nm or less as weakly as possible and further also absorb at 436 nm to lower the sensitivity to the white lamp or to inhibit the fogging caused by the white lamp, because the white lamp has the wavelength of 436 nm in its bright line spectrum. Further, yellow colorants which weakly absorb at 500 nm are preferred because colorants deeply absorbing at 500 nm turn the images to reddish purple by mixing with the blue tint of the colorant, making the register marks difficult to visually observe.

Accordingly, the yellow colorants used in the present invention must have specific proportions of absorbance at wavelengths of 436 nm, 417 nm and 500 nm, the proportions of absorbance being 100 : 65 or less : 40 or less, preferably 100 : 55 or less : 30 or less, and more preferably 100 : 42 or less : 3 or less. When the proportions of absorbance are within the above-mentioned range, the present invention can have a sufficient effect.

The yellow colorants used in the present invention are preferably, for example, compounds represented by formula [I].

In formula [I], the alkyl group for R₁, R₂, R₃, R₄ and R₅, preferably has 1 to 10 carbon atoms (for example, methyl, ethyl), and may be substituted by a substituent group such as a hydroxyl group, a cyano group, an alkoxyl group (for example, methoxy, ethoxy), a halogen atom (for example, chlorine, bromine), a carboxyl group, an alkoxycarbonyl group, a sulfonyl group, an aryl group (for example, phenyl, p-nitrophenyl), a vinyl group, a methylvinyl group, a cinnamyl group, etc.

The aryl group for R₁ and R₂, each is preferably a phenyl group or a naphthyl group. These aryl groups may be substituted by a substituent group such as an alkyl group having 1 to 10 carbon atoms, a hydroxyl group, a cyano group, an alkoxyl group having 1 to 10 carbon atoms (for example, methoxy, ethoxy), a halogen atom (for example, chlorine, bromine), a carboxyl group, an alkoxycarbonyl group, a sulfonyl group, etc.

The alkenyl group for R₁ and R₂ is preferably a vinyl group. This alkenyl group may be substituted by a substituent group such as an alkyl group having 1 to 10 carbon atoms or an aryl group having 6 to 18 carbon atoms. These substituent groups may be further substituted by an alkyl group having 1 to 10 carbon atoms (for example, methyl).

R₁ and R₂ may combine to form a ring. Examples of the ring include 5- and 6-membered rings, and 5- and 6-membered rings condensed by an aromatic ring. These rings may contain substituent groups such as an alkyl group, an aryl group, a substituted alkyl group, a substituted aryl group, a hydroxyl group, a cyano group, an alkoxyl group, a halogen atom, a carboxyl group, an alkoxycarbonyl group, and a sulfonyl group.

Although G₁ and G₂ each represents an alkoxycarbonyl group, an aryloxycarbonyl group, an acyl group, an arylcarbonyl group, an alkylthio group, an arylthio group, an alkylsulfonyl group, an arylsulfonyl group, or a fluoroalkylsufonyl group, the alkyl groups contained in the above groups preferably have 1 to 10 carbon atoms and the aryl groups contained in the above groups are preferably a phenyl group or a naphthyl group. These alkyl and aryl groups may further contain substituent groups. Examples of the substituted groups include an alkyl group having 1 to 10 carbon atoms, a hydroxyl group, an cyano group, an alkoxyl group having 1 to 10 carbon atoms, a halogen atom, a carboxyl group, an alkoxycarbonyl group, a sulfonyl group, a sulfoalkoxy group, an aryl group having 6 to 18 carbon atoms, an acyl group, a vinyl group, and a cinnamyl group.

When G₁ and G₂ combine to form rings consisting of non-metallic atoms together with the respective carbon atoms to which G₁ and G₂ link, the rings are generally ones used as acidic nuclei in merocyanine dyes. Examples of the acidic nuclei are as follows:
(1) 1,3-dicarbonyl nuclei such as 1,3-indanedione, 1,3-cyclohexanedione, 5,5-dimethyl-1,3-cyclohexanedione, and 1,3-dioxane-4,6-dione,
(2) pyrazolinone nuclei such as 3-methyl-1-phenyl-2-pyrazolin-5-one, 1-phenyl-2-pyrazolin-5-one, and 1-(2-benzothiazoline)-3-methyl-2-pyrazolin-5-one,
(3) isooxazolinone nuclei such as 3-phenyl-2-isooxazolin-5-one and 3-methyl-2-isooxazolin-5-one,
(4) oxyindole nuclei such as 1-alkyl-2,3-dihydro-2-oxyindole,
(5) 2,4,6-triketohexahydropyrimidine nuclei such as barbituric acid, 2-thiobarbituric acid and their derivatives, wherein examples of the derivatives include 1-alkyl derivatives (for example, 1-methyl, 1-ethyl), 1,3-dialkyl derivatives (for example, 1,3-diethyl, 1,3-dibutyl), 1,3-diaryl derivatives [for example, 1,3-diphenyl, 1,3-di(p-chlorophenyl), 1,3-di(p-ethoxycarbonyl-phenyl), and 1-alkyl-3-aryl derivatives (for example, 1-ethyl-3-phenyl),
(6) 2-thio-2,4-thiazolidinedione nuclei such as rhodamine and its derivatives wherein examples of the derivatives include 3-alkylrhodanine such as 3-ethylrhodanine and 3-allylrhodanine and 3-arylrhodanine such as 3-phenylrhodanine,
(7) 2-thio-2,4-oxazolidinedione [2-thio-2,4-(3H,5H)-oxazoledione] nuclei such as 2-ethyl-2-thio-2,4-oxazolidinedione,
(8) thianaphthenone nuclei such as 3(2H)-thianaphthenone and 3(2H)-thianaphthenone-1,1-dioxide,
(9) 2-thio-2,5-thiazolidinedione nuclei such as 3-ethyl-2-thio-2,5-thiazolidinedione,
(10) 2,4-thiazolidinedione nuclei such as 2,4-thiazolidinedione, 3-ethyl-2,4-thiazolidinedione and 3-phenyl-2,4-thiazolidinedione,
(11) thiazolidinone nuclei such as 4-thiazolidinone and 3-ethyl-4-thiazolidinone,
(12) 4-thiazolinone nuclei such as 2-ethylmercapto-5-thiazolin-4-one and 2-alkylphenylamino-5-thiazolin-4-one,
(13) 2-imino-2-oxozolin-4-one (pseudohydantoin) nuclei,
(14) 2,4-imidazolidinedione (hydantoin) nuclei such as 2,4-imidazolidinedione and 3-ethyl-2,4-imidazolidinedione,
(15) 2-thio-2,4-imidazolidinedione (2-thiohydantoin) nuclei such as 2-thio-2,4-imidazolidinedione and 3-ethyl-2-thio-2,4-imidazolidinedione,
(16) 2-imidazolin-5-one nuclei such as 2-n-propylmercapto-2-imidazolin-5-one,
(17) furan-5-one,
(18) 4-hydroxy-2(1H)-quinolinone nuclei or 4-hydroxy-2(1H)-pyridinone nuclei such as N-methyl-4-hydroxy-2(1H)-quinolinone, N-n-butyl-4-hydroxy-2(1H)-quinolinone and N-methyl-4-hydroxy-2(1H)-pyridinone,
(19) substituted or unsubstituted 4-hydroxy-2H-pyran-2-one and 4-hydroxycoumarin, and
(20) substituted or unsubstituted thioindoxyl such as 5-methylthioindoxyl.
n represents 0 or 1.
Y is a divalent atom or an atomic group selected from the group consisting of O, S, -NR-, Se, -C(CH₃)₂-, and -CH=CH-, wherein R has the same meaning as R₃.

Examples of compounds represented by formula [I] are as follows:

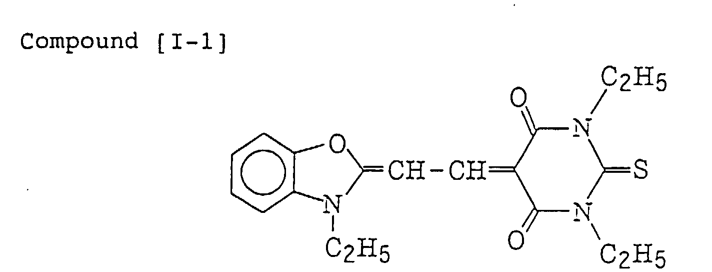

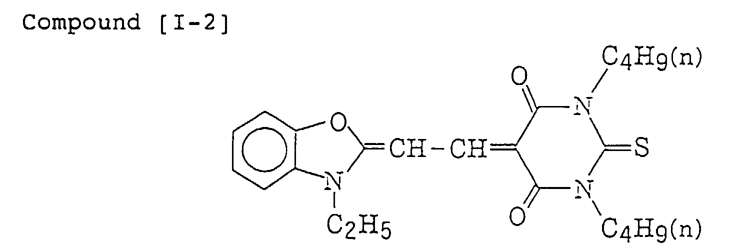

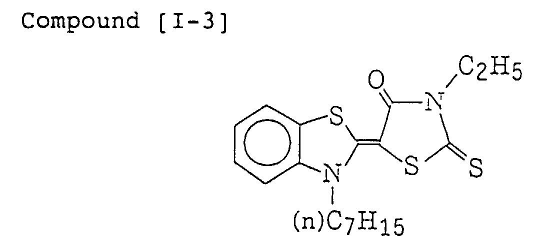

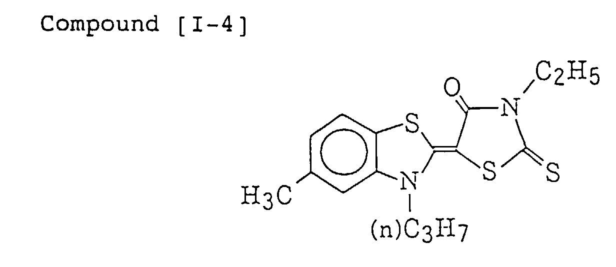

The formula [II] of the present invention is explained below.

In formula [II], R₁₁, R₁₂, R₁₃, R₁₄, R₁₅, R₁₆ and R₁₇ each represents a hydrogen atom, a halogen atom, an alkyl group, a substituted alkyl group, an aryl group, a substituted aryl group, an allyl group, and a substituted allyl group. R₁₂ and R₁₃ may combine to form a ring together with the respective carbon atoms to which R₁₂ and R₁₃ link.

Of these groups, the alkyl groups described above are one having 1 to 12 carbon atoms (for example, methyl, ethyl, n-propyl, isopropyl, n-butyl, or t-butyl) and the aryl groups described above are one having 6 to 10 carbon atoms (for example, phenyl, naphthyl), and the allyl groups described above are one having 3 to 10 carbon atoms. These alkyl, aryl and allyl groups may contain substituent groups. Examples of substituent groups include an alkyl group having 1 to 6 carbon atoms (for example, methyl. ethyl), an alkoxyl group having 1 to 6 carbon atoms (for example, methoxy, ethoxy), a halogen atom (for example, chlorine, bromine), a cyano group, an amino group, an amino group substituted by a alkyl group having 1 to 4 carbon atoms (for example, dimethylamino), an alkoxycarbonyl group in which the alkyl moiety has 1 to 4 carbon atoms (for example, methoxycarbonyl), substituted and unsubstituted aryl groups which have 6 to 10 carbon atoms (for example, phenyl, p-methoxyphenyl, p-chlorophenyl), a carboxyl group and a sulfonic acid group, and their salts.

R₁₂ and R₁₃ may combine to form a ring together with the respective carbon atoms to which R₁₂ and R₁₃ link. Examples of the rings include aliphatic hydrocarbon rings (for example, cyclohexene), aromatic rings (for example, benzene, naphthalene), and heteroaromatic rings (for example, quinoline). These rings may contain substituent groups which are the same groups as the substituent groups used for R₁₁, R₁₂, R₁₃, R₁₄, R₁₅, R₁₆, and R₁₇.

The compounds represented by formula [II] which are used in the present invention can be prepared according to well-known methods. Typical methods of preparing these compounds are described in, for example, The Theory of Photographic Process, the 4th edition, edited by T.H. James, Macmillan Co., New York (1977); F.M. Hamer, The Cyanine Dyes and Related Compounds, John Wiley & Sons Co., New York (1964); and JP-A-61-203443 (The term "JP-A" as used herein means an "unexamined published Japanese patent application").

Examples of preferred compounds represented by formula [II] include the above-describeded Compounds [I-1] and [I-2].

Although photosensitive compounds used in the present invention are not particularly limited, o-naphthoquinonediazide is preferred.

Polyhydroxyphenyl compounds exhibiting safety against the white lamp can also be used. These compounds are described in JP-B-4-31104 (The term "JP-B" as used herein means an "examined Japanese patent publication"). Examples of the polyhydroxyphenyl compounds include condensation products between pyrogallol and acetone described in U.S. Patent 3,635,709, polyesters containing at terminal hydroxyl groups described in U.S. Patent 4,028,111, a homopolymer of p-hydroxystyrene or its copolymers with the other copolymerizable monomers as described in British Patent 1,494,043, copolymers of p-aminostyrene with the other copolymerizable monomers as described in U.S. Patent 3,759,711, and phenol-formaldehyde resins or cresol-formaldehyde resins described in U.S. Patent 3,046,120. Particularly, by using the condensation products between pyrogallol and acetone, the photosensitive compositions excellent in sensitivity and development latitude can be prepared.

When a polyhydroxyphenyl compound is used in the present invention, the molar ratio of 1,2-naphthoquinone-2-diazide-5-sulfonyl halide (A) to 1,2-naphthoquinone-2-diazide-4-sulfonyl halide (B) which are condensed with the polyhydroxy-phenyl compound preferably ranges from 2 : 8 to 8 : 2. Proportions of halide (B) exceeding this range cause the resulting photosensitive compositions to deteriorate their sensitivity and stability with time. The proportions not reaching this range often cause the resulting photosensitive compositions to lower their safety against the fluorescent lamp. The above-mentioned molar ratio [(A):(B)] is more preferably from 3 : 7 to 7 : 3.

Among other o-quinonediazide compounds which can be used as the photosensitive components in the photosensitive compositions of the present invention, esters prepared by the reaction of 1,2-naphthoquinone-2-diazide-5-sulfonyl chloride with pyrogallol-acetone resins are most preferred. Other preferable well-known o-quinonediazide compounds are esters prepared from 1,2-naphthoquinone-2-diazide-5-sulfonyl chloride and phenol-formaldehyde resins described in U.S. Patents 3,046,120 and 3,188,210. The other well-known o-naphthoquinonediazide compounds which can be used in the present invention are described in JP-A-47-5303, JP-A-48-63802, JP-A-48-63803, JP-A-48-96575, JP-A-49-38701, JP-A-48-13354, JP-B-41-11222, JP-B-45-9610, JP-B-49-17481, U.S. Patents 2,797,213, 3,454,400, 3,544,323, 3,573,917, 3,674,495, and 3,785,825, British Patents 1,227,602, 1,251,345, 1,267,005, 1,329,888, and 1,330,932, German Patent 854,890, etc.

The amount of a photosensitive compound (preferably, o-quinonediazide compounds) in the photosensitive composition of the present invention ranges preferably from 10 to 80% by weight, more preferably from 15 to 50% by weight, and most preferably from 20 to 35% by weight.

Although o-naphthoquinonediazide compounds used as the photosensitive compounds can form photosensitive layers by themselves, these compounds are preferably used together with aqueous alkali-soluble resins as binders. As such aqueous alkali-soluble resins, there are novolak resins. Examples of the resins include phenol-formaldehyde resins and cresol-formaldehyde resins such as m-cresol-formaldehyde resins, p-cresol-formaldehyde resins, o-cresol-formaldehyde resins, m-/ p-cresol-formaldehyde resins, phenol-cresolformaldehyde resins (Herein, the cresol may be m-, p-, or o-isomer, a mixture of m- and p-isomers, or a mixture of m- and o-isomers). Besides these, resol-type phenolic resins are suitably used. Among the resins, preferred are phenol-cresol-formaldehyde resins (Herein, the cresol may be m-, p-, or o-isomer, a mixture of m- and p-isomers, or a mixture of m- and o-isomers) and, particularly, phenolic resins described in JP-A-61-217034 are preferred.

Further, various types of alkali-soluble high-molecular compounds are employed, which include phenol-modified xylene resins, polyhydroxystyrene, polyhalogenated hydroxystyrene, phenolic hydroxyl group-containing acrylic resins as disclosed in JP-A-51-34711, sulfonamido group-containing acrylic resins described in JP-A-2-866, and urethane resins. These alkali-soluble high-molecular compounds preferably have weight average molecular weights of 500 to 20,000 and number average molecular weights of 200 to 60,000.

Such alkali-soluble high-molecular compounds may be used singly or as a mixture of two or more compounds. The content of the alkali-soluble high-molecular compounds in the whole composition is preferably 80% by weight or less, more preferably from 30 to 75% by weight, and most preferably from 50 to 65% by weight. This range secures good development characteristics and impression capacity.

Further, condensation products of formaldehyde with phenols substituted by an alkyl group having 3 to 8 carbon atoms such as t-butylphenol-formaldehyde resins or octylphenol-formaldehyde resins as described in U.S. Patent 4,123,279 are preferably used together with the above-mentioned aqueous alkali-soluble high-molecular compounds, which causes the images to be improved in ink receptivity.

In order to improve sensitivity, cyclic acid anhydrides, phenols, or organic acids are preferably added to the photosensitive composition in the present invention. Examples of the cyclic acid anhydrides include phthalic acid anhydride, tetrahydrophthalic acid anhydride, hexahydrophthalic acid anhydride, 3,6-endoxo-Δ⁴-tetrahydrophthalic acid anhydride, tetrachlorophthalic acid anhydride, maleic acid anhydride, chloromaleic acid anhydride, α-phenylmaleic acid anhydride, succinic acid anhydride, and pyromellitic acid anhydride. Examples of the phenols include bisphenol A, p-nitrophenol, p-ethoxyphenol, 2,3,4-trihydroxybenzophenone, 4-hydroxybenzophenone, 2,4,4'-trihydroxybenzophenone, 4,4',4"-trihydroxytriphenylmethane, 4,4',3",4"-tetrahydroxy-3,5,3',5'-tetramethyltriphenylmethane.

As the organic acids, there are sulfonic acids, sulfinic acids, alkylsulfuric acids, phosphonic acids, phosphinic acids, phosphoric acid esters, and carboxylic acids as described in JP-A-60-88942 and JP-A-2-96755. Examples thereof include p-toluenesulfonic acid, dodecylbenzenesulfonic acid, p-toluenesulfinic acid, ethylsulfuric acid, phenylphosphonic acid, phenylphosphinic acid, phenyl phosphate, diphenyl phosphate, benzoic acid, isophthalic acid, adipic acid, p-toluic acid, 3,4-dimethoxybenzoic acid, phthalic acid, terephthalic acid, 1,4-cyclohexene-2,2-dicarboxylic acid, erucic acid, lauric acid, n-undecanoic acid, and ascorbic acid. The content of the above-mentioned cyclic acid anhydrides, phenols, or organic acids in the photosensitive composition is preferably from 0.05 to 15% by weight, and more preferably from 0.1 to 5% by weight.

In order to increase development latitude, nonionic surfactants as described in JP-A-62-251740 and JP-A-4-68355 and amphoteric surfactants as described in JP-A-59-121044 and JP-A-13149 can be added to the photosensitive composition of the present invention. Examples of the nonionic surfactants include sorbitan tristearate, sorbitan monopalmitate, sorbitan trioleate, stearic acid monoglyceride, polyoxyethylene sorbitan monooleate, and polyoxyethylene nonyl phenyl ether. Examples of amphoteric surfactants include alkyldi(aminoethyl)glycine, alkyl-polyaminoethylglycine hydrochloride, Amorgen K (trade name, manufactured by Dai-ichi Kogyo Seiyaku Co.. Ltd., an N-tetradecyl-N,N-betaine type surfactant), 2-alkyl-N-carboxyethyl-N-hydroxyethylimidazolium betaine, and Lebon 15 (trade name, manufactured by Sanyo Chemical Industries, Ltd., an alkylimidazoline type surfactant). The content of these nonionic surfactants or amphoteric surfactants in the photosensitive composition is preferably from 0.05 to 15% by weight, and more preferably from 0.1 to 5% by weight.

In the present invention, dyes and other fillers can be added as print-out agents or image-coloring agents to the photosensitive composition to obtain visible images immediately after exposure. The dyes which can be used in the present invention include basic dyes which are salts formed from cations having skelton structures of basic dyes and organic anions having 10 or more carbon atoms and 1 to 3 hydroxyl groups, the organic anions containing a sulfonic acid group as an only salt-formable group described in JP-A-5-313359. The content thereof in the whole photosensitive composition is preferably from 0.2 to 5% by weight.

Compounds which release decomposition products by photolysis to allow to change color tones of the images by interaction with the dyes described in JP-A-5-313359 can be added to the photosensitive composition. Examples of such the compounds include o-naphthoquinonediazide-4-sulfonic acid halogenide described in JP-A-50-36209 (corresponding to U.S. Patent 3,969,118), trihalomethyl-2-pyrone and trihalomethyltriazine described in JP-A-53-36223 (corresponding to U.S. Patent 4,160,671), various o-naphthoquinonediazide compounds described in JP-A-55-62444 (corresponding to U.S. Patent 2,038,801), and 2-trihalomethyl-5-aryl-1,3,4-oxadiazole compounds described in JP-A-55-77742 (corresponding to U.S. Patent 4,279,982). These compounds can be employed singly or in admixture with one another.

Besides the dyes described in the above-described JP-A-5-313359, the other dyes can be employed as image-coloring agents. Preferred dyes are oil soluble dyes and basic dyes as well as salt-formable organic dyes. Examples thereof include Oil Green BG, Oil Blue BOS, Oil Blue #603 (All the above dyes are manufactured by Orient Chemical Co., Ltd.), Victoria Pure Blue BOH (manufactured by Hodogaya Chemical Co., Ltd.), Rhodamine B (C145170B), Malachite Green (C142000), and Methylene Blue (C152015).

When photosensitive planographic printing plates are prepared from the photosensitive compositions of the present invention, hydrophilized aluminum plates are employed as supports, which are, for example, silicate-treated aluminum plates, anodized aluminum plates, grained aluminum plates, and silicate-electrodeposited aluminum plates. Examples of the other supports include zinc plates, stainless steel plates, chrome-treated steel plates, hydrophilized plastic films, and paper.

The photosensitive planographic printing plate of the present invention is prepared by coating a support with a solution in which all components used for the photosensitive composition as described above are dissolved in a solvent. Examples of solvents used for the purpose include γ-butyrolactone, ethylene dichloride, cyclohexanone, methyl ethyl ketone, ethylene glycol monomethyl ether, ethylene glycol monoethyl ether, 2-methoxyethyl acetate, 1-methoxy-2-propanol, 1-methoxy-2-propyl acetate, toluene, ethyl acetate, methyl lactate, ethyl lactate, dimethylsulfoxide, dimethylacetamide, dimethylformamide, water, N-methylpyrrolidone, tetrahydrofurfuryl alcohol, acetone, diacetone alcohol, methanol, ethanol, isopropanol, and diethylene glycol dimethyl ether. The above solvents may be used singly or in admixture with one another. The content of solid components in the photosensitive composition is preferably from 2 to 50% by weight. Although the coating amount of the solid components varies depending on uses, in general, it is preferably from 0.5 to 3.0 g/m². Less coating amount causes higher photosensitivity, but deteriorates physical properties of the resulting photosensitive film.

Surfactants, for example, fluorine-based surfactants as described in JP-A-62-170950, can be added to the photosensitive layer of the present invention to improve coating properties. The content thereof in the whole photosensitive composition is preferably from 0.01 to 1% by weight and more preferably from 0.05 to 0.5% by weight. A surface of the photosensitive layer thus provided is preferably matted to save time required for evacuation in contact exposure using a vacuum printing frame and to inhibit lack of sharpness in printing. For example, a method of forming a matting layer as described in JP-A-50-125805, JP-B-57-6582 and JP-B-61-28986 and a method of heat-fusing solid powders to the surface as described in JP-B-62-62337 may be applied to this purpose.

Preferred developers for the photosensitive planographic printing plate of the present invention are aqueous alkaline solutions which do not substantially contain organic solvent. Suitable examples of the aqueous alkaline solutions include sodium silicate, potassium silicate, sodium hydroxide, potassium hydroxide, lithium hydroxide, sodium tertiary phosphate, sodium secondary phosphate, ammonium tertiary phosphate, ammonium secondary phosphate, sodium metasilicate, sodium carbonate, sodium bicarbonate, potassium carbonate, potassium bicarbonate, ammonia, etc. The concentration of the above compounds is adjusted so as to be preferably from 0.1 to 10% by weight, and more preferably from 0.5 to 5% by weight. Among these compounds, alkali silicates such as potassium silicate, lithium silicate and sodium silicate are preferably used for the developers, because use of the alkali silicate-containing developers does not nearly stain during the printing operation. When, with respect of the composition of alkali silicate, the molar ratio of [SiO₂]/[M] is from 0.5 to 2.5 (Herein, [SiO₂] and [M] represent molar concentrations of SiO₂ and the entire alkali metals contained, respectively) and, in addition, the content of SiO₂ in the developer is preferably from 0.8 to 8% by weight, the developers are preferably used. Further, water-soluble sulfites such as sodium sulfite, potassium sulfite and manganese sulfite, resorcine, methylresorcine, hydroquinone, and thiosalicylic acid can be added to the developers. The content of these compounds in the developer is preferably from 0.002 to 4% by weight, and more preferably from 0.01 to 1% by weight.

Further, at least one surfactant selected from anionic and amphoteric surfactants as described in JP-A-50-51324 and JP-A-59-84241 and nonionic surfactants as described in JP-A-59-75255, JP-A-60-111246 and JP-A-60-213943 or poly-electrolytes as described in JP-A-55-95946 and JP-A-56-142528 can also be preferably added to the developer to improve wettability to the photosensitive composition and stability of development (development latitude). The content of such surfactants is preferably from 0.001 to 2% by weight, and more preferably from 0.003 to 0.5% by weight. Further, with respect to the above-described alkali silicates, the content of potassium contained as the alkali metal thereof in the developer is preferably 20 mol% or more, more preferably 90 mol% or more, and most preferably 100 mol%, because little insoluble matter is formed in the developer. Furthermore, a small amount of organic solvent such as alcohol, chelating agents described in JP-A-58-190952, metal salts as described in JP-B-1-30139, and anti-foaming agents such as organic silane compounds can be added to the developer used in the present invention. Examples of light sources used for exposure include a carbon arc lamp, a mercury vapor lamp, a xenon lamp, a tungsten lamp, a metal halide lamp, etc.

In the photosensitive planographic printing plates of the present invention, the treatment of platemaking may be carried out according to methods described in JP-A-54-8002, JP-A-55-115045 and JP-A-59-58431. That is, after development, the desensitizing treatment after water washing, the desensitizing treatment without water washing, a treatment with an aqueous solution containing an acid, or the desensitizing treatment after a treatment with the aqueous solution containing an acid may be carried out. Further, during development for the photosensitive planographic printing plates, the concentration of alkali in the developer is decreased by its consumption owing to increase of printing plates treated or by the action of oxygen when prolonged operation of an automatic processing machine is conducted, resulting in deteriorating the capability of the developer in treating the printing plates. Use of a replenisher may recover the treatment capability as described in JP-A-54-62004 and, then, the replenishment is preferably carried out according to a method described in U.S. Patent 4,882,246. The above-mentioned treatment of platemaking is preferably conducted by the use of an automatic processing machine as described in JP-A-2-7054 and JP-A-2-32357. After the photosensitive planographic printing plate of the present invention is subjected to image exposure, development, and water washing or a rinse, if necessary, removal of unnecessary image areas is preferably carried out by a deletion fluid as described in JP-B-2-13293. Preferred desensitizing gums which may be coated, if desired, at the final step of the treatment of platemaking are those which are described in JP-B-62-16834, JP-B-62-25118, JP-B-63-52600, JP-A-62-7595, JP-A-62-11693, and JP-A-62-83194. When the photosensitive planographic printing plate of the present invention undergoes burning after image exposure, development, water washing or a rinsing, the removal treatment of unnecessary image areas, if desired, and water washing, the printing plate is preferably treated with a burning conditioner prior to the burning as described in JP-B-61-2518, JP-B-55-28062, JP-A-62-31859, and JP-A-61-159655.

The present invention is explained in greater detail with reference to the following examples. In the examples, percents are by weight, unless otherwise referred to.

### EXAMPLES 1 TO 9 AND COMPARATIVE EXAMPLES 1 TO 15

A surface of a 0.30 mm-thick aluminum plate was grained with an aqueous suspension of pumistone of 400 meshes using a nylon brush and then fully washed with water. The plate was etched by dipping in 10% sodium hydroxide at 70°C for 60 seconds, washed with running water, and neutralized and washed with 20% HNO₃, followed by washing with water. Electrolytically graining treatment of the etched surface was conducted at a quantity of electricity on an anode of 160 coulombs/dm² in a 1% aqueous solution of nitric acid using alternating wave shape current of sine wave under the condition of V_{A} = 12.7 V. The surface roughness was measured to be 0.6 µm (Rₐ indication). Subsequently, the plate was dipped in a 30% aqueous solution of H₂SO₄ at 55°C for 2 minutes to desmut it, and thereafter, anodized in a 20% aqueous solution of H₂SO₄ at a current density of 2 A/dm² so as to be 2.7 g/m² in thickness, thus preparing a substrate.

The surface of the aluminum plate thus treated was coated with a undercoating solution (A) having the following composition and then dried at 80°C for 30 seconds. The coating weight was 30 mg/m² after drying.

| Undercoating Solution (A): | |
|---|---|
| Aminoethylphosphonic Acid | 0.10 g |
| Phenylphosphonic Acid | 0.15 g |
| Triethanolamine | 0.05 g |
| β-Alanine | 0.10 g |
| Methanol | 40 g |
| Pure Water | 60 g |

Thus, substate (I) was prepared.

Subsequently, substrate (I) was coated with the following photosensitive solution using rod coating so as to be 25 ml/m² in coating build-up and then dried at 100°C for 1 minute to obtain a positive type photosensitive planographic printing plate. The coating amount was about 1.7 g/m² after drying.

| Photosensitive Solution: | |
|---|---|
| Esterified Product between 1,2-Diazonaphthoquinone-5-sulfonyl Chloride and a Pyrogallol-Acetone Resin (described in Example 1 of U.S. Patent 3,635,709) | 0.45 g |
| Cresol-Formaldehyde Novolak Resin (m-/p-Cresol Ratio = 6/4, Weight Average Molecular Weight: 3,000, Number Average Molecular Weight: 1,100. 0.7% of unreacted cresol was contained) | 1.1 g |
| m-Cresol-Formaldehyde Novolak Resin (Weight Average Molecular Weight: 1,700, Number Average Molecular Weight: 600. 1% of unreacted cresol was contained) | 0.3 g |
| Condensation Product between Pyrogallol and Acetone (Weight Average Molecular Weight: 2,200, Number Average Molecular Weight: 700) | 0.1 g |
| Copolymer of N-(p-Aminosulfonylphenyl)-acrylamide, n-Butyl Acrylate and Diethylene Glycol Monomethyl Ether Methacrylate (Molar Ratio of the Monomers = 40 : 40 : 20 in this order. Weight Average Molecular Weight: 40,000, Number | |
| Average Molecular Weight: 20,000) | 0.2 g |
| p-N-Octylphenol-Formaldehyde Resin (described in U.S. Patent 4,123,279) | 0.02 g |
| Naphthoquinonediazide-1,2-diazide-4-sulfonic Acid Chloride | 0.01 g |
| Tetrahydrophthalic Acid Anhydride | 0.02 g |
| Benzoic Acid | 0.02 g |
| 4-[p-N-(p-Hydroxybenzoyl)aminophenyl]-2,6-bis(trichloromethyl)-s-triazine | 0.02 g |
| N-(1,2-Naphthoquinone-2-diazide-4-sulfonyloxy)-cyclohexane-1,2-dicarboxylic Acid Imide | 0.01 g |
| Dye Prepared by Replacement of the Counter Anion of Victoria Pure Blue BOH (manufactured by Hodogaya Chemical Co., Ltd.) by 1-Naphthalenesulfonic Acid (Yellow-Orange Colorant) | see Table 1 |
| 1-[α-Methy-α-(4-hydroxy-3,5-dihydroxymethylphenyl)ethyl]-4-[α,α-bis(4-hydroxy-3,5-dihydroxymethylphenyl)ethyl]benzene [Compound (X) described in JP-A-6-282067] | 0.04 g |
| Megafack F-176 (Fluorine-based surfactant manufactured by Dainippon Ink and Chemicals, Inc.) | 0.01 g |
| Methyl Ethyl Ketone | 20 g |

The photosensitive planographic printing plates thus prepared were evaluated according to the following methods. The color of the images was determined by visual inspection under a white lamp (a fluorescent lamp). Subsequently, register marks were put on the photosensitive planographic printing plates with an blue oily ball-point pen and the ease with which the register marks were visually observed was evaluated by visual inspection under an yellow fluorescent lamp. The printing plates were further exposed to a metal halide lamp of 3 kw for 1 minute at a distance of 1 m through a transparent positive film in a vacuum printing frame and then developed with a 5.26 % aqueous solution of sodium silicate (pH = 12.7) at 25°C for 30 seconds, the sodium silicate being 1.74 in a molar ratio of SiO₂ to Na₂. The ease with which the images were observed under the white lamp was determined by visual inspection to evaluate the suitability for plate inspection to the developed printing plates. To evaluate the sensitivity, the photosensitive planographic printing plates were exposed to light through a Step Wedge manufactured by Fuji Photo Film Co., Ltd. (difference of density between each step: 0.15) and then developed according to the same method as the above. The sensitivity was represented by a number of clear steps. A greater number of clear steps exhibits higher sensitivity. To evaluate the safety against the white lamp, the photosensitive planographic printing plates were exposed to a white fluorescent lamp at 500 luces for 15 minutes, and thereafter, exposed to light through a transparent positive film and developed in the same manner as described above to observe lacking in the image areas by visual inspection. The results are shown in Table 1.

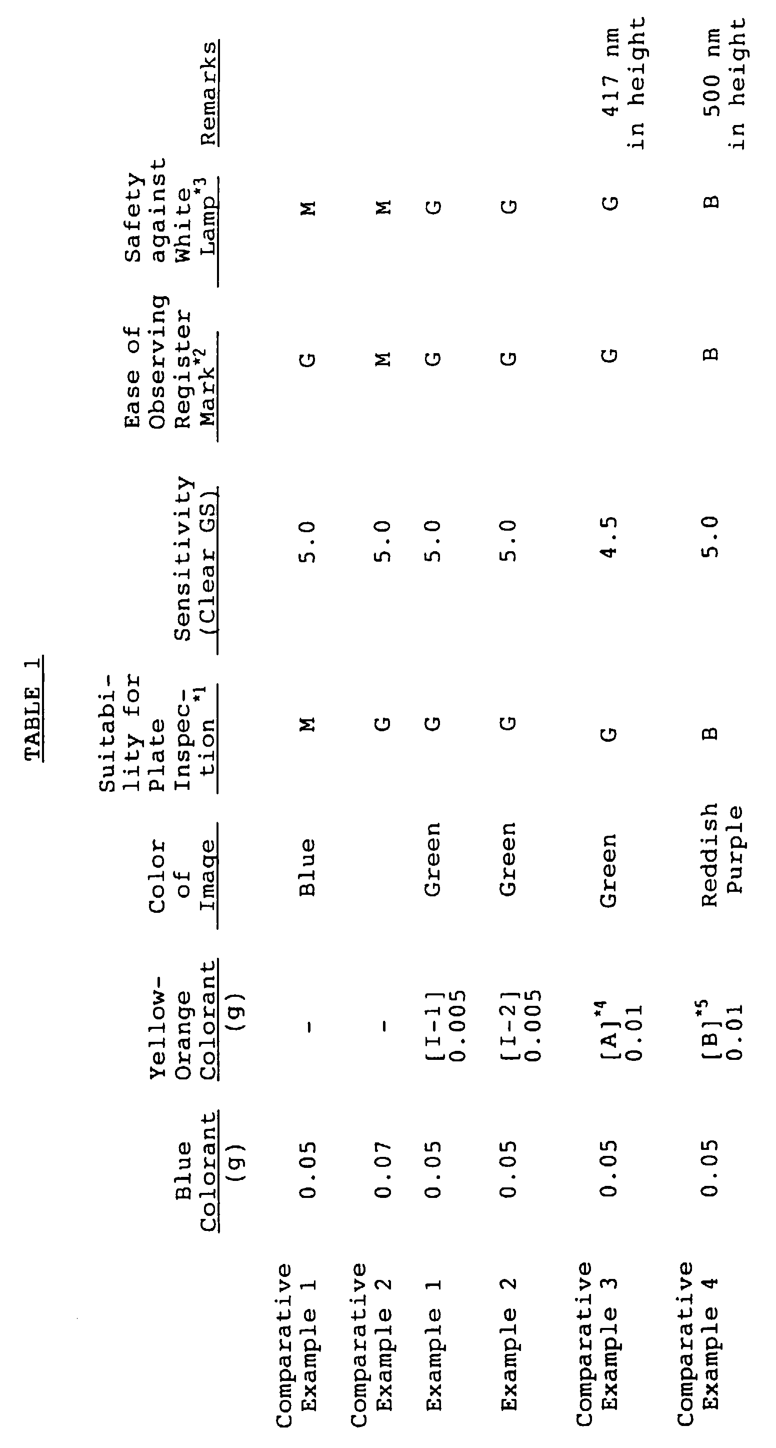

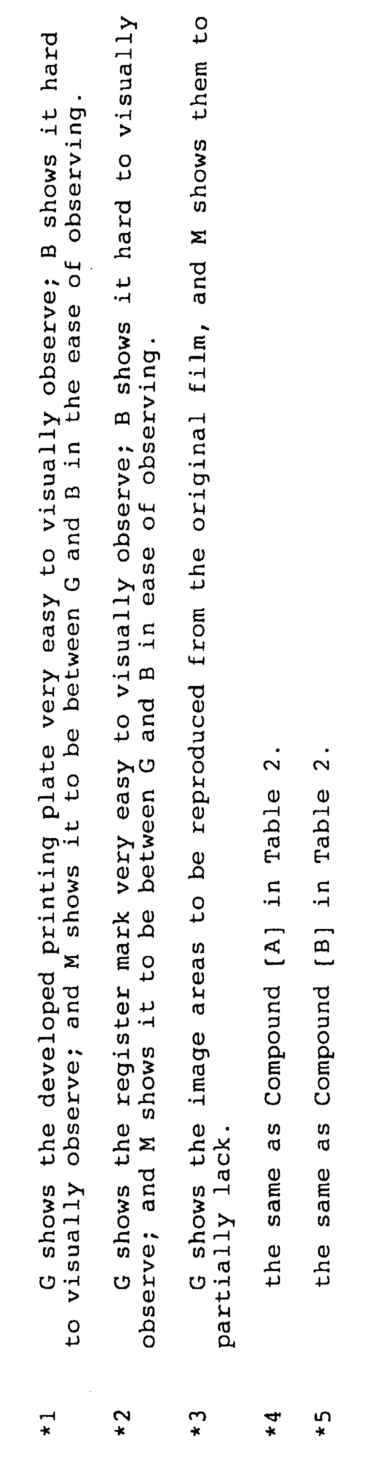

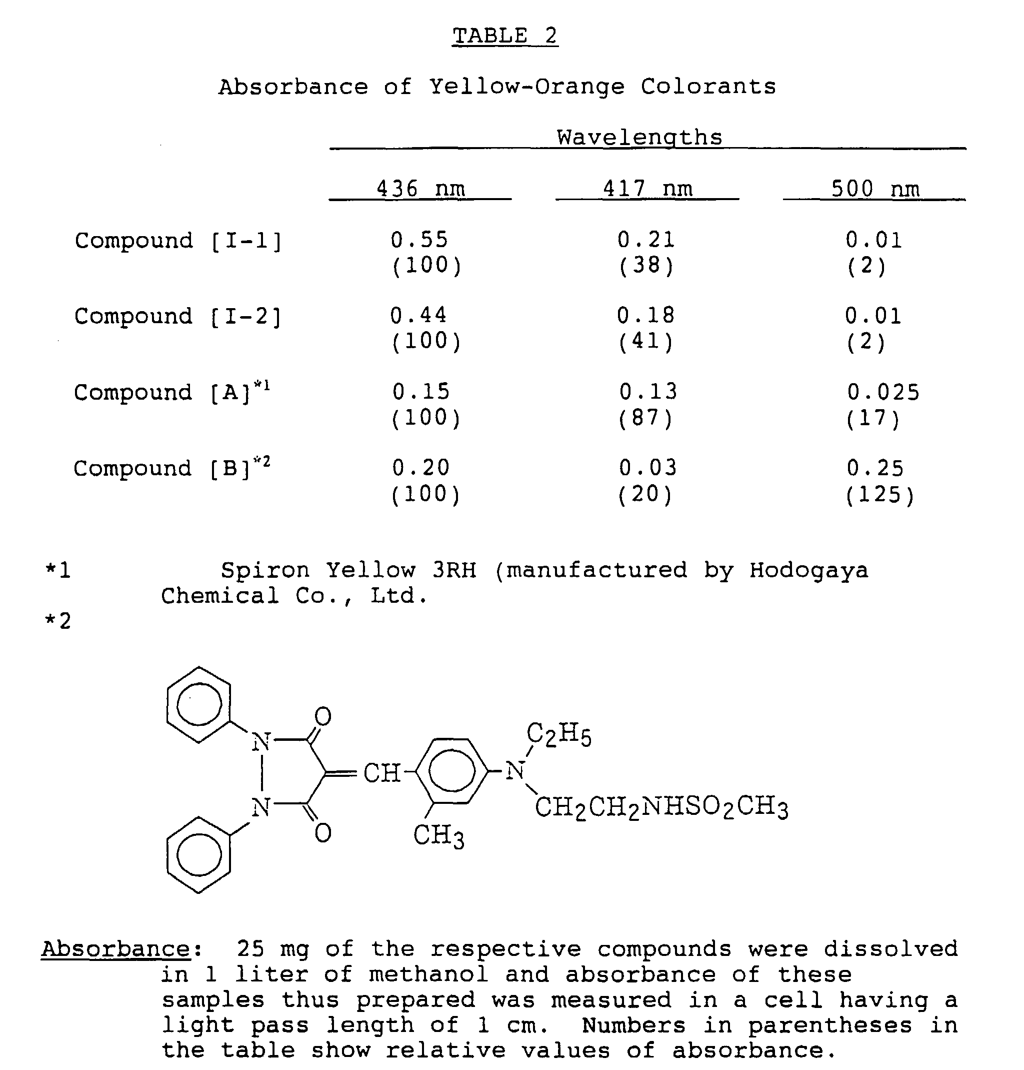

These results show that the present invention can provide photosensitive planographic printing plates having improved safety against the white lamp, improved suitability for plate inspection to the developed printing plates, and in addition, greater ease with which the register marks are visually observed.

## Claims

1. A photosensitive planographic printing plate comprising a support thereon a photosensitive composition, wherein said photosensitive composition comprises a) an o-naphthoquinonediazide compound; b) an aqueous alkali-soluble, water-insoluble polymer; c) a blue-colorant; and d) a colorant of which the proportion of absorbance at wavelengths of 436 nm, 417 nm and 500 nm is 100 : 65 or less : 40 or less.

2. The photosensitive planographic printing plate as claimed in claim 1, wherein said colorant d) is a compound represented by formula [I]: 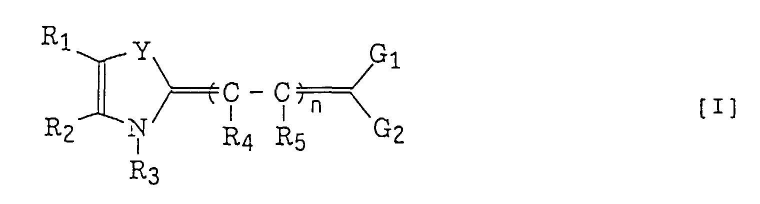 wherein R₁ and R₂, each represents an alkyl group having 1 to 10 carbon atoms which may be substituted or an aryl group having 1 to 10 carbon atoms which may be substituted; R₃ represents an alkyl group having 1 to 10 carbon atoms; R₄ and R₅, each represents a hydrogen atom or an alkyl group having 1 to 10 carbon atoms which may be substituted; G₁ and G₂, each represents an alkoxycarbonyl group, an aryloxycarbonyl group, an acyl group, an arylcarbonyl group, an alkylthio group, an arylthio group, an alkylsulfonyl group, an arylsulfonyl group, or a fluoroalkylsulfonyl group; Y represents a divalent atom or an atomic group selected from the group consisting of O, S, -NR-, Se, -C(CH₃)₂-, and -CH=CH-, wherein R has the same meanig as R₃; and n represents 0 or 1; R₁ and R₂ may combine to form a ring; and G₁ and G₂ may combine to form a ring.

3. The photosensitive planographic printing plate as claimed in claim 1, wherein said colorant d) is a compound represented by formula [II]: 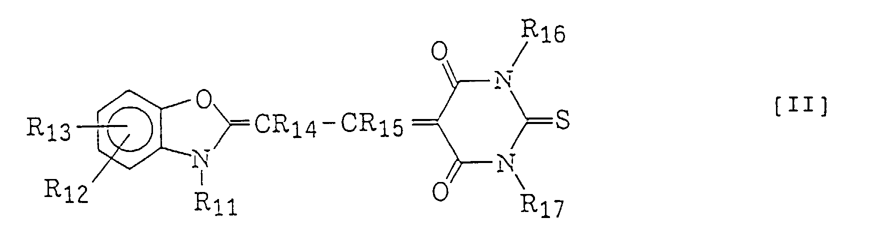 wherein R₁₁, R₁₂, R₁₃, R₁₄, R₁₅, R₁₆, and R₁₇, each represents a hydrogen atom, a halogen atom, an alkyl group, a substituted alkyl group, an aryl group, a substituted aryl group, an allyl group or a substituted allyl group; and R₁₂ and R₁₃ may combine to form a ring together with the respective carbon atoms to which R₁₂ and R₁₃ link.

4. The photosensitive planographic printing plate as claimed in claim 1, wherein said o-naphthoquinonediazide compound a) is used in an amount of from 10 to 80 % by weight in the photosensitive composition.

5. The photosensitive planographic printing plate as claimed in claim 1, wherein said o-naphthoquinonediazide a), said aqueous alkali-soluble, water-insoluble polymer b), said blue-colorant c) and said colorant d) are used in an amount of 10 to 80 by weight, 20 to 80 % by weight, 0.2 to 5 % by weight and 0.05 to 3 % by weight, respectively.

## Patentansprüche

1. Eine lichtempfindliche Flachdruckplatte mit einem Träger und einer darauf befindlichen lichtempfindlichen Schicht, worin die lichtempfindliche Schicht umfaßt a) eine o-Naphthochinondiazidverbindung; b) ein wäßriges, in Alkali lösliches und in Wasser unlösliches Polymer; c) einen blau färbenden Stoff; und d) einen färbenden Stoff, dessen Verhältnis des Absorptionsmaßes bei Wellenlängen von 436 nm, 417 nm und 500 nm 100 : 65 oder weniger: 40 oder weniger beträgt.

2. Die lichtempfindliche Flachdruckplatte wie in Anspruch 1 beansprucht, worin der färbende Stoff d) eine durch die Formel [I] wiedergegebene Verbindung ist: 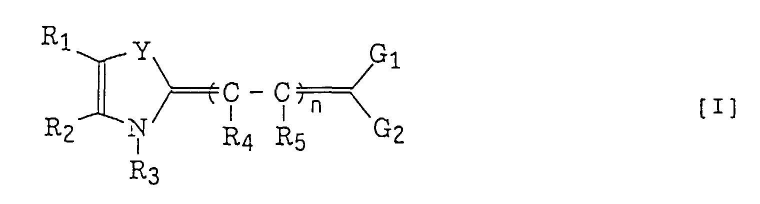 worin R₁ und R₂ jeweils eine Alkylgruppe mit 1 bis 10 Kohlenstoffatomen, die substituiert sein kann, oder eine Arylgruppe mit 1 bis 10 Kohlenstoffatomen, die substituiert sein kann, bedeuten; R₃ eine Alkylgruppe mit 1 bis 10 Kohlenstoffatomen bedeutet; R₄ und R₅ jeweils ein Wasserstoffatom oder eine Alkylgruppe mit 1 bis 10 Kohlenstoffatomen die substituiert sein kann, bedeuten; G₁ und G₂ jeweils eine Alkoxycarbonylgruppe, eine Aryloxycarbonylgruppe, eine Acylgruppe, eine Arylcarbonylgruppe, eine Alkylthiogruppe, eine Arylthiogruppe, eine Alkylsulfonylgruppe, eine Arylsulfonylgruppe oder eine Fluoralkylsulfonylgruppe bedeuten; Y ein divalentes Atom oder eine Atomgruppe bedeutet, ausgewählt aus der Gruppe bestehend O, S, -NR-, Se, -C(CH₃)₂- und -CH=CH-, worin R die gleiche Bedeutung hat wie R₃; und n 0 oder 1 bedeutet; R₁ und R₂ miteinander verbunden sein können, um einen Ring zu bilden; und G₁ und G₂ miteinander verbunden sein können, um einen Ring zu bilden.

3. Die lichtempfindliche Flachdruckplatte wie in Anspruch 1 beansprucht, worin der färbende Stoff d) eine durch die Formel [II] wiedergegebene Verbindung ist: 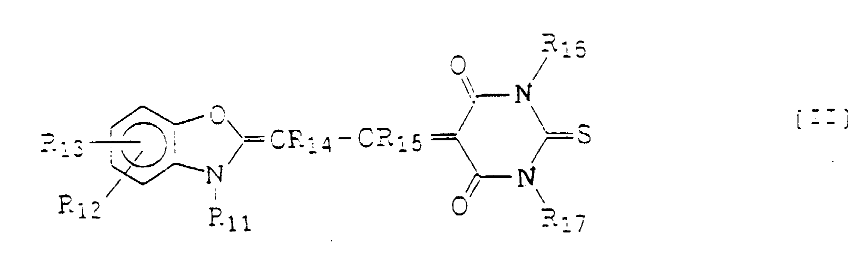 worin R₁₁, R₁₂, R₁₃, R₁₄, R₁₅, R₁₆ und R₁₇ jeweils ein Wasserstoffatom, ein Halogenatom, eine Alkylgruppe, eine substituierte Alkylgruppe, eine Arylgruppe, eine substituierte Arylgruppe, eine Allylgruppe oder eine substituierte Allylgruppe bedeuten; und R₁₂ und R₁₃ miteinander verbunden sein können, um einen Ring zusammen mit den betreffenden Kohlenstoffatomen zu bilden, an welche R₁₂ und R₁₃ binden.

4. Die lichtempfindliche Flachdruckplatte wie in Anspruch 1 beansprucht, worin die o-Naphthochinondiazidverbindung a) in einer Menge von 10 bis 80 Gew.-% in der lichtempfindlichen Zusammensetzung verwendet wird.

5. Die lichtempfindliche Flachdruckplatte wie in Anspruch 1 beansprucht, worin das o-Naphthochinondiazid a), das wäßrige, in Alkali lösliche und in Wasser unlösliche Polymer b), der blau färbende Stoff c) und der färbende Stoff d) in einer Menge von 10 bis 80 Gew.-%, 20 bis 80 Gew.-%, 0,2 bis 5 Gew.-% bzw. 0,05 bis 3 Gew.-% verwendet werden.

## Revendications

1. Plaque photosensible pour l'impression planographique comprenant un support ayant sur celui-ci une composition photosensible, caractérisée en ce que ladite composition photosensible comprend a) un composé o-naphtoquinonediazide ; b) un polymère insoluble dans l'eau, soluble dans un alcali aqueux ; c) un colorant bleu ; et d) un colorant dont la proportion d'absorbance à des longueurs d'onde de 436 nm, 417 nm et 500 nm est 100 : 65 ou moins : 40 ou moins.

2. Plaque photosensible pour l'impression planographique telle que revendiquée dans la revendication 1, caractérisée en ce que ledit colorant d) est un composé représenté par la formule [I]: 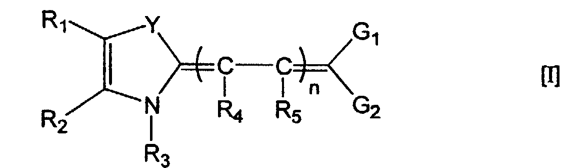 dans laquelle R₁ et R₂, représentent chacun un groupe alkyle ayant 1 à 10 atomes de carbone qui peut être substitué ou un groupe aryle ayant 1 à 10 atomes de carbone qui peut être substitué; R₃ représente un groupe alkyle ayant 1 à 10 atomes de carbone ; R₄ et R₅ représentent chacun un atome d'hydrogène ou un groupe alkyle ayant 1 à 10 atomes de carbone qui peut être substitué; G₁ et G₂ représentent chacun un groupe alcoxycarbonyle, un groupe aryloxycarbonyle, un groupe acyle, un groupe arylcarbonyle, un groupe alkylthio, un groupe arylthio, un groupe alkylsulfonyle, un groupe arylsulfonyle, ou un groupe fluoroalkylsulfonyle ; Y représente un atome divalent ou un groupe atomique choisi dans le groupe constitué par O, S, -NR-, Se, -C(CH₃)₂₋, et -CH = CH-, où R a la même signification que R₃; et n représente 0 ou 1 ; R₁ et R₂ peuvent se combiner pour former un cycle ; et G₁ et G₂ peuvent se combiner pour former un cycle.

3. Plaque photosensible pour l'impression planographique telle que revendiquée dans la revendication 1, caractérisée en ce que ledit colorant d) est un composé représenté par la formule [II]: 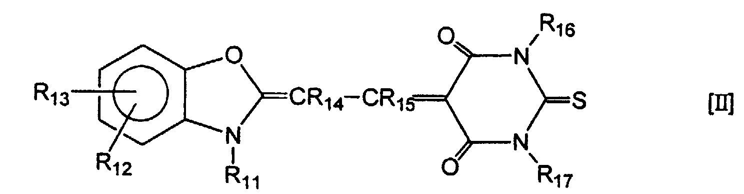 dans laquelle R₁₁, R₁₂, R₁₃, R₁₄, R₁₅, R₁₆, et R₁₇, représentent chacun un atome d'hydrogène, un atome d'halogène, un groupe alkyle, un groupe alkyle substitué, un groupe aryle, un groupe aryle substitué, un groupe allyle ou un groupe allyle substitué ; et R₁₂ et R₁₃ peuvent se combiner pour former ensemble un cycle avec les atomes de carbone respectifs auxquels R₁₂ et R₁₃ sont liés.

4. Plaque photosensible pour l'impression planographique telle que revendiquée dans la revendication 1, caractérisée en ce que ledit composé o-naphtoquinonediazide a) est utilisé en une quantité de 10 à 80% en poids de la composition photosensible.

5. Plaque photosensible pour l'impression planographique telle que revendiquée dans la revendication 1, caractérisée en ce que ledit composé o-naphtoquinonediazide a), ledit polymère b) insoluble dans l'eau, soluble dans un alcali aqueux, ledit colorant bleu c) et ledit colorant d) sont utilisés en une quantité de 10 à 80% en poids, 20 à 80% en poids, 0,2 à 5% en poids et 0,05 à 3% en poids, respectivement.
